# EUROPÄISCHE PATENTSCHRIFT

(11) **EP 1 380 197 B1**
(45) Veröffentlichungstag und Bekanntmachung des Hinweises auf die Patenterteilung: **14.03.2007**
(21) Anmeldenummer: 02724126.4
(22) Anmeldetag: 03.04.2002
(51) Int. Cl.: H05K 13/00

(54) **EINRICHTUNG ZUM KENNZEICHNEN VON BAUELEMENTENMAGAZINEN UND VERFAHREN ZUR VERWENDUNG DER EINRICHTUNG**
DEVICE FOR CHARACTERISING COMPONENT STORES AND METHOD FOR USING SAID DEVICE
DISPOSITIF DE CARACTERISATION DES STOCKS DE COMPOSANTS, ET PROCEDE UTILISANT CE DISPOSITIF

(30) Priorität: 19.04.2001 DE 10119232
(43) Veröffentlichungstag der Anmeldung: 14.01.2004
(73) Patentinhaber: SIEMENS AKTIENGESELLSCHAFT, 80333 München (DE)
(72) Erfinder: ESCHENWECK, Friedrich, 85622 Feldkirchen (DE)
(86) Internationale Anmeldenummer: PCT/DE2002/001210
(87) Internationale Veröffentlichungsnummer: WO 2002/087302

(56) Entgegenhaltungen:
- WO-A-00/67546
- DE-A- 19 804 594
- DE-U- 29 919 674

## Beschreibung

Die Erfindung betrifft eine Einrichtung zum Kennzeichnen von mit einer Mehrzahl zu bestückender elektrischer Bauelemente versehenen Bauelementemagazinen, insbesondere für Bestückanlagen mit Transportvorrichtungen, Bestückköpfen und Zuführmodulen zum Bestücken der elektrischen Bauelemente, sowie ein Verfahren zum Verwenden der Einrichtung.

Aus der DE 199 40 584 A1 ist ein Verfahren und ein System zum Bestücken von in einer Bestückungseinheit angeordneten Schaltungsträgern bekannt, bei welchen elektronische Bauelemente in einem Gebinde bereitgehalten werden und das Gebinde zu bestimmten Zuführspuren der Bestückungseinheit dadurch zugeordnet wird, daß jeweils bäuelementbezogene Daten auf den Gebinden zugeordneten Identifikationsträgern mit den Daten von sogenannten Rüstkontrollträgern verglichen werden. Hierdurch wird eine sichere und zuverlässige Kontrolle über die Zuordnung erzielt.

Aus der JP 8-264994 A ist ein Bestückautomat und aus der JP 7-76364 A ist ein Verfahren zur Bestückung von Leiterplatten mit elektronischen Bauelementen bekannt, wobei ein an einem Bauelementegurt angebrachter Barcode dazu verwendet wird, um die in dem Bauelementegurt befindlichen elektronischen Bauelemente zu kennzeichnen.

Aus der DE 25 57 110 A1 und aus der GB 2 287 860 A ist bekannt, dass zu bestückende Bauelemente auch dadurch gekennzeichnet und identifiziert werden können, dass die Kennzeichnung bzw. ein Identifizierungsmerkmal direkt auf dem jeweiligen Bauelement angebracht sein kann.

Aus der DE 199 19 915.9 sind ein Verfahren und eine Vorrichtung zum Bestücken von Substraten mit Bauelementen sowie ein Substrat bekannt, wobei das Substrat mit einem Transponder versehen ist, in welchen Daten über die auf dem Substrat bestückten Bauelemente speicherbar und lesbar sind.

Bei diesem Verfahren werden über eine Steuereinrichtung nach dem Bestücken der Bauelemente über eine Kommunikationseinheit Daten des Bestückprozesses in eine in dem oder an dem Substrat angeordnete kontaktlose Datenspeichereinheit übertragen. Die Daten werden in der Datenspeichereinheit abgespeichert und von einer Ausleseeinheit ausgelesen, sowie mittels einer Kontrolleinheit für eine Auswertung des Bestückprozesses herangezogen. Mit dieser bekannten Lösung kann ferner nicht sichergestellt werden, dass an den Zuführeinrichtungen eines Bestückautomaten die in einem Bestückprogramm für den durchzuführenden Bestückprozess vorgesehenen Bauelementetypen bereitgestellt sind.

Nach der DE 198 04 594 ist ein tablettförmiges Bauelementemagazin bekannt geworden, bei dem die Bauelemente in zwei Koordinatenrichtungen verteilt in entsprechenden Taschen des Magazins wahlfrei zugänglich aufgenommen sind. In einer der Taschen ist anstelle eines der Bauelemente ein Transponder eingesetzt, der mit den spezifischen Typdaten der Bauelemente beschrieben ist. Aufgrund der freien Zugänglichkeit der Taschen können die Transponderdaten jederzeit problemlos ausgelesen werden

Mit diesem Verfahren ist es bei der zugehörigen Bestückvorrichtung und dem entsprechenden Substrat möglich, in einem Bestückprozess Informationen über die an einem Bestückautomaten noch vorhandenen Stückzahlen elektrischer Bauelemente und Typen elektrischer Bauelemente zu verarbeiten, sowie eine eindeutige Zuordnung der verarbeiteten Bauelemente zu den bestückten Substraten vorzunehmen.

Bei der Verwendung von in Gurten magazinierten Bauelementen besteht das Problem, dass ein am Gurtanfang plazierter und damit gut zugänglicher Transponder mit Beginn der Verarbeitung bereits entfernt werden müsste, so dass beim Einsetzen eines bereits teilweise verbrauchten Gurtes keine Identifizierung möglich wäre. Ferner ist es für einen optimalen Bestückprozessverlauf erforderlich, die Magazine entsprechend rechtzeitig zu wechseln, damit keine Stillstandszeiten auftreten.

Der Erfindung liegt daher die Aufgabe zugrunde, eine Einrichtung und ein Verfahren anzugeben, mittels welchem der Bestückprozess unter Verwendung von in Gurten magazinierten Bauelementen einfacher, sicherer und schneller durchgeführt werden kann.

Diese Aufgabe wird gelöst durch eine Einrichtung mit den Merkmalen nach Anspruch 1 sowie ein Verfahren mit den Merkmalen nach Anspruch 11. Bevorzugte Ausgestaltungen der Erfindung sind in den abhängigen Ansprüchen beansprucht.

Erfindungsgemäß wird eine Einrichtung zum Kennzeichnen von mit einer Mehrzahl zu bestückender elektrischer Bauelemente versehener Bauelementemagazinen geschaffen. Diese ist insbesondere für Bestückanlagen mit Transportvorrichtungen, Bestückköpfen und Zuführmodulen zum Bestücken der elektrischen Bauelemente geeignet und weist mindestens einen mit den zu bestückenden Bauelementen gekoppelten Datenträger auf, in welchem zumindest technische Daten der Bauelemente eingespeichert sind. Der Datenträger ist mittels einer Bearbeitungseinheit erfassbar. In dem Datenträger können weitere technische Bauelementedaten, logistische Bauelementedaten und/oder Betriebsdaten der Bestückanlage gespeichert sein oder gespei chert werden. Das Bauelementemagazin weist eine Mehrzahl von Vertiefungen zum Aufnehmen von Bauelementen auf. In einer der Vertiefungen ist der Datenträger angeordnet, welcher erfindungsgemäß als Transponder realisiert ist. Durch die erfindungsgemäße Einrichtung ist es möglich, an Zuführmodulen einer Bestückanlage zur Verfügung gestellte Bauelemente eindeutig zu identifizieren und zu überprüfen, ob die zur Verfügung gestellten Bauelemente mit den in einem Bestückprogramm für einen durchzuführenden Bestückprozess vorgesehenen Bauelementen übereinstimmen. Außerdem ist es durch die erfindungsgemäße Einrichtung möglich, Fehlerprotokolle und/oder ein Protokoll des Gesamtverlaufs des Bestückprozesses der Bestückanlage aufzuzeichnen und auszuwerten.

Erfindungsgemäß wird bei den Bestückanlagen, bei welchen Bauelemente sukzessive aus gurtartigen Bauelementemagazinen entnehmbar sind, der Datenträger in der Nähe des Magazinendes angeordnet ist. Es ist üblich, dass der weit überwiegende Anteil der Bauelemente in solchen Gurtmagazinen angeleifert wird. Der dem Gurtende zugeordnete Transponder befindet sich somit im schwer zugänglichen inneren Bereich der Gurtspule und kann dort z.B. mit Hilfe einer manuell bewegbaren Leseeinrichtung abgetastet werden, die mit der Bestückanlage verbunden ist. Der Transponder ist am Gurtende derart angeordnet, dass er vor Entnehmen des letzten Bauelements aus dem mit dem Datenträger gekoppelten Bauelementemagazin durch eine Detektiervorrichtung erfassbar ist. Hierdurch wird zusätzlich zur Überwachung der Anzahl der in dem Bauelementemagazin verbliebenen Bauelemente sichergestellt, dass vor dem Entnehmen des letzten Bauelements aus einem Bauelementemagazin ein Signal an eine Steuervorrichtung gesendet werden kann, welche den Bestückprozess steuert. Durch ein derartiges Erfassen des Datenträgers kann sichergestellt werden, dass die Zuführeinrichtungen der Bestückanlage rechtzeitig mit einem neuen Bauelementemagazin versehen werden können.

Das Bauelementemagazin kann beispielsweise ein Bauelementegurt sein. Dies bietet den Vorteil, dass für den Datenträger keine gesonderte Befestigungsvorrichtung vorgesehen werden muss. Beispielsweise kann der Datenträger in der Umgebung des Gurtendes eines Bauelementegurtes in einer der letzten Vertiefungen des Bauelementegurtes angeordnet sein. Der Datenträger kann eine Antenne aufweisen. Die Antenne kann beispielsweise in der Vertiefung angeordnet sein, in welcher auch der Datenträger angeordnet ist. Es ist auch möglich, dass sich die Antenne über eine Mehrzahl von Vertiefungen auf dem Bauelementegurt erstreckt.

Der Datenträger kann beispielsweise durch Anbringen an dem Bauelementemagazin mit den Bauelementen gekoppelt sein. Es ist jedoch auch möglich, dass der Datenträger in den Bauelementen selbst integriert ist. Es sind auch andere Möglichkeiten der Kopplung des erfindungsgemäßen Datenträgers mit den Bauelementemagazinen möglich, welche eine feste Zuordnung zwischen Datenträger und Bauelement sicherstellen. Durch Kopplung ist eine eindeutige Zuordnung von Bauelementetypen zu Zuführmodulen einer Bestückanlage möglich. Außerdem sind Daten über physikalische Eigenschaften der Bauelemente, wie beispielsweise Güte und Fehlerhaftigkeit, etc. der Bauelemente in dem Datenträger speicherbar und durch die Kopplung zwischen Datenträger und Bauelement während des gesamten Bestückprozesses nachvollziehbar.

Die Betriebsdaten können auch Angaben über die Anzahl der in dem Bauelementemagazin verbliebenen Bauelemente, Angaben über den Betrieb der Bestückanlage, und/oder technische Angaben über die Bestückanlage aufweisen. Insbesondere können auf dem Datenträger folgende Informationen abgespeichert sein: Zahl der Bauteile eines vollen Bauelementemagazins, technische Daten des Bauelements, wie beispielsweise Typ, Wert, Größe, Toleranz, Temperaturkoeffizient oder Herstelldatum, Informationen über das Bauelementemagazin, über den Typ des Bauelemen temagazins, über den Abstand der Bauelemente in dem Bauelementemagazin, über die Abmessungen der Lagerstellen der Bauelemente in dem Bauelementemagazin, Informationen über den Hersteller, über die Charge, über das Datum des Wareneingangs, die Lieferantennummer, über interne Bezeichnungen für Bauelementetypen bzw. Gehäusebezeichnungen von Bauelementetypen, die noch vorhandene Anzahl der Bauelemente eines teilweise entleerten Bauelementemagazins, sowie Daten über die Zuführeinrichtung, wie beispielsweise über den Typ der Zuführeinrichtung, die Seriennummer der Zuführeinrichtung, die Anzahl und die Art der aufgetretenen Fehler sowie über Zeitangaben, usw..

Erfindungsgemäß wird auch ein Verfahren zur Verwendung der erfindungsgemäßen Einrichtung geschaffen, bei welchem auf dem Datenträger gespeicherte Angaben gelesen werden, die gelesenen Angaben mittels einer Steuereinheit ausgewertet werden, und die Bauelemente aufgrund der ausgewerteten Angaben zu in einem Bestückprogramm vorgesehenen Bestückorten auf zu bestückenden Substraten zugeordnet werden. Dabei kann erfindungsgemäß während des Auswertens der gelesenen Angaben mittels der Steuereinheit beispielsweise überprüft werden, ob in den Zuführmodulen der Bestückvorrichtung die in dem Bestückprogramm für die Bestückorte vorgesehenen Bauelementetypen vorhanden sind. Es können, je nach Art des Datenträgers, auch Angaben über den Ablauf des Bestückens der Bauelemente in den Datenträger geschrieben werden und/oder es können Bauelementdaten der auf das Substrat bestückten Bauelemente in den Datenträger geschrieben werden. Dies ermöglicht das Aufzeichnen von aufgetretenen Unregelmäßigkeiten und/oder Bestückfehlern sowie die Überprüfung der technischen Daten der während des Bestückprozesses tatsächlich auf das Substrat bestückten Bauelemente.

Es ist möglich, eine Fehlermeldung auszugeben, wenn, insbesondere bei Bestückanlagen, bei welchem Bauelemente aus Bau elementemagazinen sukzessive entnehmbar sind, der Datenträger vor dem Entnehmen des letzten Bauelements aus dem mit dem Datenträger gekoppelten Bauelementemagazin von der Detektiervorrichtung erfasst worden ist. Durch die ausgegebene Fehlermeldung kann signalisiert werden, dass ein neues Bauelementemagazin eingelegt werden muss, um ein kontinuierliches Bestücken während des Bestückprozesses sicherzustellen.

Nach Beendigung des Bestückprozesses kann die Anzahl der jeweils in den Bauelementemagazinen verbliebenen Bauelemente in die den Bauelementemagazinen jeweils zugeordneten Datenträger geschrieben werden. Somit ist bei einer Weiterverwendung der teilweise entleerten Bauelementemagazine ein exaktes Planen des nächsten Bestückvorganges möglich, da die Anzahl der in einem auch nur teilweise entleerten Bauelementemagazin vorhandenen Bauelemente jederzeit auslesbar ist.

Die Erfindung wird unter Bezugnahme auf die Zeichnung näher erläutert. In der Zeichnung zeigen:
Figur 1 eine Draufsicht auf eine erste bevorzugte Ausführungsform der Erfindung,
Figur 2 eine Draufsicht auf eine zweite bevorzugte Ausführungsform der Erfindung, und
Figur 3 eine perspektivische Ansicht einer weiteren Ausführungsform der Erfindung.

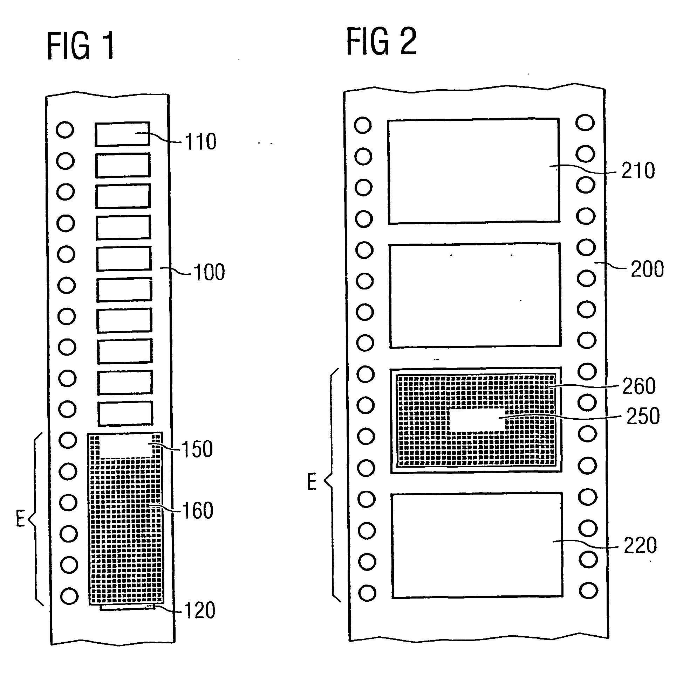

Wie aus Figur 1 ersichtlich, weist die erste bevorzugte Ausführungsform nach der Erfindung einen Datenträger 150 mit einer Antenne 160 auf. Die Antenne 160 ist dabei beispielsweise als Folienantenne aufklebbar. Der Datenträger 150 ist in einer Vertiefung 120 eines Bauelementegurtes 100 angeordnet. In dem Bauelementegurt 100 ist eine Vielzahl von Bauelementen 110 in Vertiefungen 120 angeordnet. Die mit dem Datenträger 150 verbundene Antenne 160 erstreckt sich über eine Mehrzahl von Vertiefungen 120 des Bauelementegurtes 100 und ist auf dessen Oberfläche angeordnet. Der Datenträger 150 und die Antenne 160 können beispielsweise im Endbereich E des Bauelementegurtes 100 angeordnet sein, so dass ein Erfassen des Datenträgers 150 als Signal für einen bevorstehenden Wechsel des Bauelementegurtes 100 dienen kann.

Aus Figur 2 ist eine zweite bevorzugte Ausführungsform nach der Erfindung ersichtlich. Die zweite bevorzugte Ausführungsform der Erfindung ist insbesondere zur Verwendung mit breiten Bauelementegurten 200 geeignet, wie aus Figur 2 ersichtlich, welche mit einer Vielzahl von Bauelementen 210 in Vertiefungen 220 versehen sind. Bei breiten Bauelementegurten 200 sind die Vertiefungen 220 breiter ausgebildet und weisen eine größere Querschnittsfläche auf als bei schmalen Bauelementegurten 100. Dies dient der Aufnahme von größeren Bauelementen 210. Die Einrichtung nach der zweiten bevorzugten Ausführungsform weist einen Datenträger 250 sowie eine mit dem Datenträger 250 verbundene Antenne 260 auf. Diese sind zur Anordnung in einer der Vertiefungen 220 des Bauelementegurtes 200 geeignet, beispielsweise in einem Endbereich E des Bauelementegurtes 200. Die Antenne 260 kann dabei als Folienantenne oder als flache Spule ausgebildet sein.

Zur Erfassung des Datenträgers 150 oder 250 kann der Bauelementegurt 100 bzw. 200 durch eine beispielsweise ringförmige Empfangsantenne einer Bearbeitungseinheit hindurch geführt sein. Bei geeignet gewählter Empfindlichkeit der Antenne der Bearbeitungseinheit und/oder der Antenne, welche mit dem Datenträger 150 bzw. 250 gekoppelt ist, kann erreicht werden, dass Datenübertragungen zwischen dem Datenträger 150 bzw. 250 und der Bearbeitungseinheit (nicht gezeigt) nur in unmittelbarer Nähe der Antenne der Bearbeitungseinheit durchgeführt werden können.

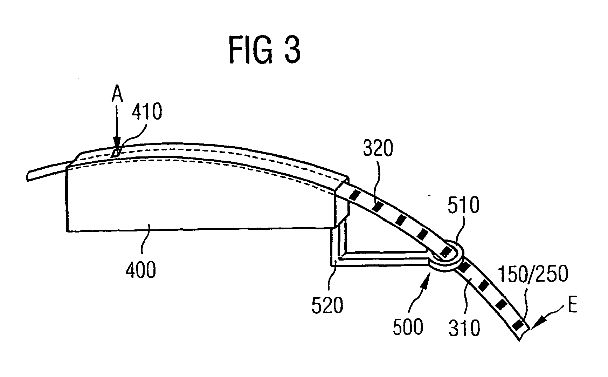

Aus Figur 3 ist eine perspektivische Ansicht einer weiteren Ausgestaltung nach der Erfindung ersichtlich. An einem Zu führmodul 400 einer Bestückvorrichtung (nicht gezeigt) werden Bauelemente 320 in einem Bauelementegurt 310 an einer Abholposition A zur Entnahme durch eine Handhabungseinrichtung (nicht gezeigt) bereitgestellt.

Durch ein Fenster 410 an der Oberseite des Zuführmoduls 400, dessen Öffnung der Abholposition A entspricht, können die Bauelemente 320 entnommen werden. In dem Bauelementegurt 310 ist auch mindestens ein Datenträger 150 bzw. 250 angeordnet, wie er oben zu den Figuren 1 und 2 beschrieben ist.

Ferner ist eine ringartige Antenne 500 vorgesehen, durch deren Ringöffnung 510 hindurch der Bauelementegurt 310 zu dem Zuführmodul 400 geführt wird. Mittels einer Stütze 520 kann die Antenne 500 an dem Zuführmodul 400 befestigt sein. Die Antenne 500 ist beispielsweise mit einer Steuervorrichtung gekoppelt, von welcher auch die Bestückvorrichtung gesteuert wird. Daher kann mittels der Antenne 500 der Datenträger erfaßt werden.

Durch geeignete Abstimmung der Empfindlichkeit der Antenne 500 kann erreicht werden, daß der Datenträger 150 bzw. 250 lediglich in der Nähe der Antenne 500 erfaßbar ist. Der Datenträger 150 bzw. 250 ist zum Beispiel in einem Endbereich E des Bauelementegurtes 310 angeordnet. Wird der Datenträger 150 bzw. 250 von der ringartigen Antenne 500 erfaßt, so kann dieses Ereignis eine Meldung auslösen, welche beispielsweise den Benutzer anweist, für das Nachfüllen eines gefüllten Bauelementegurtes zu sorgen, oder anzeigt, daß bald alle Bauelemente des betroffenen Bauelementegurtes entnommen sein werden, um Stillstandszeiten der Bestückvorrichtung zu vermeiden.

Als Datenträger kann beispielsweise ein Transponder verwendet werden, welcher berührungslos beschreibbar und lesbar ist. Es kommt auch ein selbsterhaltender elektronischer Halbleiter speicher in Frage, welcher über Kontaktstellen ausgelesen und beschrieben werden kann. Ferner ist es auch möglich, als Datenträger einen Barcode zu verwenden, welcher beispielsweise direkt auf den Bauelementegurt aufgebracht sein kann. Die Bearbeitungseinrichtung oder Steuervorrichtung ist entsprechend der Art des ausgewählten Datenträgers ausgebildet, um mit diesem kommunizieren zu können.

## Patentansprüche

1. Einrichtung zum Kennzeichnen von mit einer Mehrzahl zu bestückender elektrischer Bauelemente (110, 210) versehenen Bauelementemagazinen (100, 200, 310) für Bestückanlagen mit Transportvorrichtungen, Bestückköpfen und Zuführmodulen zum Bestücken der elektrischen Bauelemente, wobei
• die Einrichtung mindestens einen den zu bestückenden Bauelementen (110, 210) zugeordneten Datenträger (150, 250, 350) aufweist, in welchen zumindest technische Daten der Bauelemente (110, 210) eingespeichert sind,
• der Datenträger (150, 250, 350) mittels einer Bearbeitungseinheit erfaßbar ist, und
• das Bauelementemagazin (100, 200, 310) eine Mehrzahl von Vertiefungen (120, 220) zum Aufnehmen von Bauelementen aufweist und der als Transponder realisierte Datenträger (150, 250, 350) in einer der Vertiefungen (120, 220) angeordnet ist,
**dadurch gekennzeichnet, daß** die Bauelemente (110, 210) aus den gurtartigen Bauelementemagazinen (100, 200, 310) sukzessive entnehmbar sind und
daß der Datenträger (150, 250, 350) in der Nähe des Magazinendes derart angeordnet ist, daß er vor Entnehmen des letzten Bauelements aus dem mit dem Datenträger (150, 250, 350) gekoppelten Bauelementemagazin (100, 200, 310) durch eine Detektiervorrichtung erfaßbar ist.

2. Einrichtung nach Anspruch 1, **dadurch gekennzeichnet, daß** der Bauelementeträger (100, 200, 310) ein Bauelementegurt ist.

3. Einrichtung nach Anspruch 1 oder 2, **dadurch gekennzeichnet, daß** der Datenträger (150, 250, 350) beschreibbar ist.

4. Einrichtung nach Anspruch 1, 2 oder 3, **dadurch gekennzeichnet, daß** der Datenträger (150, 250, 350) durch Anbringen an dem Bauelementemagazin (100, 200, 310) mit den Bauelementen (110, 210) gekoppelt ist.

5. Einrichtung nach Anspruch 1, 2 oder 3, **dadurch gekennzeichnet, daß** der Datenträger (150, 250, 350) direkt an die Bauelemente gekoppelt ist.

6. Einrichtung nach einem der Ansprüche 1 bis 5, **dadurch gekennzeichnet, daß** der Datenträger (150, 250, 350) eine Antenne aufweist.

7. Einrichtung nach Anspruch 6, wobei die Antenne in der Vertiefung (120, 220) angeordnet ist, in welcher der Datenträger (150, 250, 350) angeordnet ist.

8. Einrichtung nach Anspruch 6, wobei die Antenne sich über einer Mehrzahl von Vertiefungen (120, 220) erstreckend auf dem Bauelementemagazin (100, 200, 310) angeordnet ist.

9. Einrichtung nach einem der Ansprüche 5 bis 8, **gekennzeichnet durch** eine ringartige, mit der Bearbeitungseinheit gekoppelte Antenne (500), **durch** welche hindurch das Bauelementemagazin (100, 200, 310) geführt ist, wobei der Datenträger (150, 250, 350) in der Nähe der mit der Bearbeitungseinheit gekoppelten Antenne (500) erfaßbar ist.

10. Einrichtung nach einem der Ansprüche 1 bis 9, wobei der Datenträger (150, 250, 350) berührungslos lesbar und beschreibbar ist.

11. Verfahren zum Kennzeichnen von mit einer Mehrzahl zu bestückender elektrischer Bauelemente (110, 210) versehenen Bauelementemagazinen (100, 200, 310) für Bestückanlagen zum Bestücken der elektrischen Bauelemente (110, 210) mit folgenden Schritten:
• Anbringen eines gurtartigen Bauelementemagazins (100, 200, 310) an einem Zuführmodul (400) einer Bestückanlage,
• Lesen der auf einem mit den zu bestückenden Bauelementen gekoppelten Datenträger (150, 250, 350) gespeicherten Angaben,
• Auswerten der gelesenen Angaben mittels einer Steuereinheit, und
• Zuordnen der Bauelemente (110, 210) aufgrund der ausgewerteten Angaben zu in einem Bestückprogramm vorgesehenen Bestückorten auf zu bestückenden Substraten,
• Erfassen des Datenträgers (150, 250, 350) in der Nähe des Magazinendes durch eine Detektiervorrichtung.

12. Verfahren nach Anspruch 11 mit folgenden Schritten:
• Schreiben von Angaben über den Ablauf des Bestückens der Bauelemente (110, 210) in den Datenträger (150, 250), und/oder
• Schreiben vom Bauelementdaten der auf das Substrat bestückten Bauelemente (110, 210) in den Datenträger (150, 250).

13. Verfahren nach Anspruch 11 oder 12 mit folgenden von der Steuereinheit durchgeführten Schritten:
• Überprüfen aufgrund der ausgewerteten Angaben, ob die an den Zuführmodulen (400) zur Verfügung gestellten Bauelementetypen den aufgrund des Bestückprogramms erforderlichen Bauelementetypen entsprechen, und
• Starten des Bestückvorgangs bei festgestellter Entsprechung der Bauelementetypen, oder
• Ausgeben einer Fehlermeldung, falls eine nicht ausreichende oder keine Entsprechung festgestellt wurde.

14. Verfahren nach einem der Ansprüche 11 bis 13, wobei von der Steuereinheit eine Meldung ausgegeben wird, wenn der Datenträger (150, 250, 350) erfaßt worden ist.

15. Verfahren nach einem der Ansprüche 11 bis 14, wobei nach Beendigung des Bestückvorgangs die Anzahl der jeweils in den Bauelementemagazinen (100, 200, 310) verbliebenen Bauelemente (110, 210) in die jeweiligen Datenträger (150, 250, 350) geschrieben wird.

## Claims

1. Device for characterising component magazines (100, 200, 310) provided with a plurality of electrical components (110, 210) to be inserted for pick-and-place tools comprising conveyor devices, insertion heads and feeder modules for inserting the electrical components, wherein
• the device has at least one data medium (150, 250, 350) assigned to the components (110, 210) to be inserted and in which at least technical data relating to the components (110, 210) is stored,
• the data medium (150, 250, 350) can be detected by means of a processing unit and
• the component magazine (100, 200, 310) has a plurality of recesses (120, 220) for accommodating components and the data medium (150, 250, 350) implemented as a transponder is disposed in one of the recesses (120, 220),
**characterised in that** the components (110, 210) can be removed successively from the tape-like component magazines (100, 200, 310) and
that the data medium (150, 250, 350) is disposed in proximity to the end of the magazine in such a way that it can be detected by means of a detection device before the last component is removed from the component magazine (100, 200, 310) linked to the data medium (150, 250, 350).

2. Device according to claim 1, **characterised in that** the component carrier (100, 200, 310) is a component tape.

3. Device according to claim 1 or 2, **characterised in that** the data medium (150, 250, 350) is writable.

4. Device according to claim 1, 2 or 3, **characterised in that** the data medium (150, 250, 350) is linked to the components (110, 210) by being attached to the component magazine (100, 200, 310).

5. Device according to claim 1, 2 or 3, **characterised in that** the data medium (150, 250, 350) is directly linked to the components.

6. Device according to one of claims 1 to 5, **characterised in that** the data medium (150, 250, 350) has an antenna.

7. Device according to claim 6, wherein the antenna is disposed in the recess (120, 220) in which the data medium (150, 250, 350) is disposed.

8. Device according to claim 6, wherein the antenna is disposed extending across a plurality of recesses (120, 220) on the component magazine (100, 200, 310).

9. Device according to one of claims 5 to 8, **characterised by** a ring-like antenna (500) linked to the processing unit, through which antenna (500) the component magazine (100, 200, 310) is guided, wherein the data medium (150, 250, 350) is detectable in close proximity to the antenna (500) linked to the processing unit.

10. Device according to one of claims 1 to 9, wherein the data medium (150, 250, 350) is readable and writable by contactless means.

11. Method for characterising component magazines (100, 200, 310) provided with a plurality of electrical components (110, 210) to be inserted for pick-and-place tools for inserting the electrical components (110, 210), comprising the following steps:
• attach a tape-like component magazine (100, 200, 310) to a feeder module (400) of a pick-and-place tool,
• read the information stored on a data medium (150, 250, 350) linked to the components to be inserted,
• analyse the information read by means of a control unit and
• assign the components (110, 210) to insertion locations provided in an insertion program on substrates to be loaded based on the analysed information,
• detect the data medium (150, 250, 350)in close proximity to the end of the magazine by means of a detection device.

12. Method according to claim 11, comprising the following steps:
• write information about the execution of the insertion of the components (110, 210) into the data medium (150, 250) and/or
• write component data relating to the components (110, 210) loaded onto the substrate into the data medium (150, 250).

13. Method according to claim 11 or 12, comprising the following steps performed by the control unit:
• check on the basis of the analysed information whether the component types made available in the feeder modules (400) correspond to the component types required on the basis of the insertion program and
• start the insertion operation when the correspondence of the component types is established or
• output an error message if an inadequate or no correspondence has been established.

14. Method according to one of claims 11 to 13, wherein a message is output by the control unit if the data medium (150, 250, 350) has been detected.

15. Method according to one of claims 11 to 14, wherein after completion of the insertion operation the number of components (110, 210) remaining in each of the component magazines (100, 200, 310) is written into the respective data media (150, 250, 350).

## Revendications

1. Dispositif pour caractériser des chargeurs de composants (100, 200, 310) dotés d'une pluralité de composants (110, 210) électriques à placer pour des installations de montage avec des dispositifs de transport, des têtes de montage et des modules d'alimentation pour le placement des composants électriques
- le dispositif présentant au moins un support de données (150, 250, 350) attribué aux composants (110, 210) à placer, dans lequel au moins des données techniques des composants (110, 210) sont stockées,
- le support de données (150, 250, 350) pouvant être détecté au moyen d'une unité de traitement, et
- le chargeur de composants (100, 200, 310) présentant une pluralité de cavités (120, 220) pour le logement de composants et le support de données (150, 250, 350) réalisé sous la forme de transpondeur étant disposé dans l'une des cavités (120, 220),
**caractérisé en ce que** les composants (110, 210) peuvent être prélevés de façon successive sur les chargeurs de composants (100, 210, 310) de type sangle et
**en ce que** le support de données (150, 250, 350) est disposé à proximité de l'extrémité de chargeur de telle sorte qu'il peut être saisi par un dispositif de détection avant le prélèvement du dernier composant du chargeur de composants (100, 200, 310) couplé avec le support de données (150, 250, 350).

2. Dispositif selon la revendication 1, **caractérisé en ce que** le support de composants (100, 200, 310) est une sangle pour composants.

3. Dispositif selon la revendication 1 ou 2, **caractérisé en ce que** le support de données (150, 250, 350) peut être écrit.

4. Dispositif selon la revendication 1, 2 ou 3, **caractérisé en ce que** le support de données (150, 250, 350) est couplé avec les composants (110, 210) par le placement sur le chargeur de composants (100, 200, 310).

5. Dispositif selon la revendication 1, 2 ou 3, **caractérisé en ce que** le support de données (150, 250, 350) est couplé directement aux composants.

6. Dispositif selon l'une quelconque des revendications 1 à 5, **caractérisé en ce que** le support de données (150, 250, 350) présente une antenne.

7. Dispositif selon la revendication 6, l'antenne étant disposée dans la cavité (120, 220) dans laquelle est disposé le support de données (150, 250, 350).

8. Dispositif selon la revendication 6, l'antenne s'étendant sur une pluralité de cavités (120, 220) et étant disposée sur le chargeur de composants (100, 200, 310).

9. Dispositif selon l'une quelconque des revendications 5 à 8, **caractérisé par** une antenne (500) de forme annulaire, couplée à l'unité de traitement, à travers laquelle le chargeur de composants (100, 200, 310) est guidé, le support de données (150, 250, 350) pouvant être détecté à proximité de l'antenne (500) couplée à l'unité de traitement.

10. Dispositif selon l'une quelconque des revendications 1 à 9, le support de données (150, 250, 350) pouvant être lu et écrit sans contact.

11. Procédé pour caractériser des chargeurs de composants (100, 200, 310) dotés d'une pluralité de composants (110, 210) électriques à placer pour des installations de montage pour le placement des composants (110, 210) électriques comprenant les étapes suivantes :
- placement d'un chargeur de composants (100, 200, 310) de type sangle sur un module d'alimentation (400) d'une installation de montage,
- lecture des indications stockées sur un support de données (150, 250, 350) couplé aux composants à placer,
- analyse des indications lues au moyen d'une unité de commande, et
- attribution des composants (110, 210) sur la base des indications analysées à des emplacements de montage prévus sur un programme de montage sur des substrats à équiper,
- détection du support de données (150, 250, 350) à proximité de l'extrémité du chargeur par un dispositif de détection.

12. Procédé selon la revendication 11, comprenant les étapes suivantes :
- enregistrement d'indications sur le déroulement du montage des composants (110, 210) dans le support de données (150, 250) et/ou
- enregistrement des données des composants (110, 210) montés sur le substrat dans le support de données (150, 250).

13. Procédé selon la revendication 11 ou 12, comprenant les étapes suivantes effectuées par l'unité de commande :
- vérification sur la base des indications analysées si les types de composants mis à disposition sur les modules d'alimentation (400) correspondent aux types de composants nécessaires sur la base du programme de montage, et
- démarrage de l'opération de montage lorsqu'on constate une équivalence des types de composants, ou
- édition d'un message d'erreur si une correspondance suffisante ou aucune correspondance n'a été constatée.

14. Procédé selon l'une quelconque des revendications 11 à 13, un message étant édité par l'unité de commande lorsque le support de données (150, 250, 350) a été détecté.

15. Procédé selon l'une quelconque des revendications 11 à 14, le nombre des composants (110, 210) restés respectivement dans les chargeurs de composants (100, 200, 310) étant enregistré dans les supports de données (150, 250, 350) respectifs après la fin de l'opération de montage.
